(19) Europäisches Patentamt
European Patent Office
Office européen des brevets

(11) **EP 3 582 276 A1**

(12) **DEMANDE DE BREVET EUROPEEN**

(43) Date de publication:
**18.12.2019 Bulletin 2019/51**

(21) Numéro de dépôt: **19179733.1**

(22) Date de dépôt: **12.06.2019**

(51) Int Cl.:
*H01L 51/44* (2006.01)    *H01L 31/18* (2006.01)
*H01L 51/42* (2006.01)    *H01L 31/0224* (2006.01)
*H01L 51/00* (2006.01)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **13.06.2018 FR 1855178**

(71) Demandeurs:
• **Armor**
  **44100 Nantes (FR)**

• **Université de Bordeaux**
  **33000 Bordeaux (FR)**
• **Institut Polytechnique de Bordeaux**
  **33400 Talence (FR)**
• **Centre National de la Recherche Scientifique**
  **75016 Paris (FR)**

(72) Inventeur: **VONGSAYSY, Uyxing**
  **33400 Talence (FR)**

(74) Mandataire: **Lavoix**
  **2, place d'Estienne d'Orves**
  **75441 Paris Cedex 09 (FR)**

(54) **FILM POUR CELLULE PHOTOVOLTAÏQUE, PROCÉDÉ DE FABRICATION, CELLULE PHOTOVOLTAÏQUE ET MODULE PHOTOVOLTAÏQUE ASSOCIÉS**

(57)    La présente invention concerne un film (24) pour cellule photovoltaïque (8) comprenant au moins un oxyde métallique et au moins un additif. L'oxyde métallique présente une bande de conduction ayant un niveau d'énergie minimal. L'additif est choisi dans le groupe constitué des hydroxydes alcalins, des hydroxydes alcalino-terreux, des matériaux semi-conducteurs ayant une orbitale moléculaire la plus haute occupée ayant un niveau d'énergie minimal en valeur absolue inférieur au niveau d'énergie en valeur absolue de la bande de conduction de l'oxyde métallique, et des matériaux dopants de type n ayant une énergie d'ionisation inférieure au niveau d'énergie minimal en valeur absolue de la bande de conduction de l'oxyde métallique.

FIG.1

**Description**

DOMAINE TECHNIQUE

La présente invention concerne un film pour cellule photovoltaïque et un procédé de fabrication du film pour cellule photovoltaïque. La présente invention porte également sur une cellule photovoltaïque comportant le film et sur un module photovoltaïque comportant au moins une cellule photovoltaïque comportant le film.

ARRIERE-PLAN TECHNOLOGIQUE

Une cellule photovoltaïque est un composant électronique qui, exposé à la lumière (photons), produit de l'électricité grâce à l'effet photovoltaïque obtenu à l'aide des propriétés de matériaux semi-conducteurs.

Il est entendu par l'expression « semi-conducteur » un matériau qui a les caractéristiques électriques d'un isolant, mais pour lequel la probabilité qu'un électron puisse contribuer à un courant électrique, quoique faible, est non négligeable. En d'autres termes, la conductivité électrique d'un semi-conducteur est intermédiaire entre la conductivité électrique des métaux et la conductivité électrique des isolants.

Le comportement des semi-conducteurs est décrit par la physique quantique en utilisant une approximation par la théorie des bandes. L'approximation par la théorie des bandes stipule qu'un électron dans un semi-conducteur ne prend que des valeurs d'énergie comprises dans des intervalles continus nommés « bandes », plus spécifiquement bandes permises, lesquelles sont séparées par d'autres « bandes » appelées bandes d'énergie interdites ou bandes interdites.

Deux bandes d'énergie permises jouent un rôle particulier : la dernière bande complètement remplie, appelée « bande de valence » et la bande d'énergie permise suivante appelée « bande de conduction ». Dans un semi-conducteur, comme dans un isolant, la bande de valence et la bande de conduction sont séparées par une bande interdite, appelée couramment par son équivalent anglais plus court « gap ».

La largeur de cette bande interdite délimite le minimum d'énergie à fournir à un électron pour passer d'un état fondamental à un état excité. L'énergie est, par exemple fournie sous forme d'énergie lumineuse.

Les semi-conducteurs sont classés en deux catégories qui sont les semi-conducteurs de type p, aussi appelés donneurs d'électrons, et les semi-conducteurs de type n, aussi appelés accepteurs d'électrons.

Dans le cas d'un semi-conducteur organique, c'est-à-dire un semi-conducteur comprenant au moins une liaison faisant partie du groupe constitué par les liaisons covalentes entre un atome de carbone et un atome d'hydrogène, les liaisons covalentes entre un atome de carbone et un atome d'azote, ou encore des liaisons entre un atome de carbone et un atome d'oxygène, l'approximation par la théorie des bandes n'est plus valable mais par analogie, des orbitales moléculaires ont le même comportement, l'orbitale HO correspondant à la bande de valence et l'orbitale BV à la bande de conduction. L'orbitale HO (acronyme pour « haute occupée ») est aussi désignée sous la terminologie anglaise d'orbitale HOMO (acronyme anglais de « highest occupied molecular orbital ») et désigne l'orbitale moléculaire la plus haute en énergie occupée par au moins un électron. L'orbitale BV (acronyme pour « basse vacante») est aussi désignée sous la terminologie anglaise d'orbitale LUMO (acronyme anglais de « lowest unoccupied molecular orbital») et désigne l'orbitale la plus basse en énergie non occupée par un électron.

Un moyen de caractériser les performances d'une cellule photovoltaïque est le calcul du rendement de conversion.

Il est entendu par « rendement de conversion » d'une cellule photovoltaïque le rapport de l'énergie électrique maximale en sortie de la cellule photovoltaïque sur l'énergie lumineuse reçue par la cellule photovoltaïque. Le rendement de conversion permet de caractériser la fraction de l'énergie lumineuse captée au départ que l'on retrouve sous forme électrique injectée sur le réseau.

Une cellule photovoltaïque est obtenue par le dépôt de plusieurs couches dont une couche assure le transport des électrons. Cette couche est la couche conductrice d'électrons, aussi appelée « electron transport layer » en anglais, ou ETL.

La couche conductrice d'électrons est formée à base d'oxyde métallique. L'oxyde de titane ($TiO_2$) et l'oxyde de zinc (ZnO) sont généralement employés comme matériaux constituant la couche conductrice d'électrons en raison de leurs caractéristiques avantageuses dans le cadre de la fabrication industrielle des cellules photovoltaïques, telles que leur faible coût, leur facilité de synthèse, leur non toxicité, leur grande stabilité et leurs propriétés optiques et électroniques.

Cependant, utiliser une couche conductrice d'électrons comprenant un oxyde métallique implique un temps d'irradiation à un rayonnement ultra-violet avant que la cellule photovoltaïque ne remplisse ses fonctions électroniques. Une cellule photovoltaïque n'est entièrement fonctionnelle qu'une fois qu'elle a été exposée à la lumière pendant un certain temps, dit temps de photo-activation ou temps d'activation.

Des temps de photo-activation avoisinant les trente minutes ont été reportés dans l'article de Lilliedal M. et al.

"The effect of post processing treatments on inflection points in current-voltage curves of roll-to-roll processed polymer photovoltaics.", Sol. Energy Mat. & Solar cells 94 (2010) : 2018-2031. Les cellules photovoltaïques testées comportent une couche conductrice d'électrons obtenue à partir d'une solution de nanoparticules d'oxydes de zinc. Après avoir été stockées plusieurs semaines dans l'obscurité, les cellules photovoltaïques sont exposées à un rayonnement ultra-violet et les performances électriques des cellules sont mesurées. Il a été observé que les cellules photovoltaïques n'atteignent leur rendement de conversion optimal qu'au bout d'un temps avoisinant les trente minutes.

La cellule photovoltaïque ne délivre pas instantanément sa puissance électrique maximale et le temps d'attente est source d'inconfort pour l'utilisateur. De plus, lorsque des mesures électriques sont pratiquées lors du développement ou du suivi de production des cellules photovoltaïques, la présence d'un temps d'activation nuit à la productivité des mesures.

RESUME DE L'INVENTION

Un but de la présente invention est d'obtenir des cellules photovoltaïques capables d'atteindre le maximum de puissance électrique en un temps grandement réduit, ce temps pouvant notamment être inférieur à une minute, tout en étant simples et peu onéreuses à fabriquer à l'échelle industrielle.

A cet effet, il est proposé un film pour cellule photovoltaïque comprenant au moins un oxyde métallique et au moins un additif. L'oxyde métallique présente une bande de conduction ayant un niveau d'énergie minimal. L'additif est choisi dans le groupe constitué des hydroxydes alcalins, des hydroxydes alcalino-terreux, des matériaux semi-conducteurs et des matériaux dopants de type n. Lesdits matériaux semi-conducteurs ont une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique. Les matériaux dopants de type n ont une énergie d'ionisation inférieure au niveau d'énergie minimal en valeur absolue de la bande de conduction de l'oxyde métallique.

Il est également proposé un film pour cellule photovoltaïque comprenant au moins un oxyde métallique et au moins un additif. L'oxyde métallique présente une bande de conduction ayant un niveau d'énergie minimal. L'additif est choisi dans le groupe constitué des hydroxydes alcalins, des hydroxydes alcalino-terreux, et des matériaux semi-conducteurs de type n. Lesdits matériaux ont une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique.

Grâce à un tel film, les cellules photovoltaïques présentent un temps de photo-activation grandement réduit, le temps de photo-activation pouvant en particulier être inférieur à une minute pour certaines compositions de film. Les cellules photovoltaïques comportant un tel film fonctionnent sans temps de photo-activation ou avec un temps de photo-activation réduit, tout en maintenant des performances initiales comparables à celles d'une cellule photovoltaïque ne comprenant pas d'additif dans la couche conductrice d'électrons.

Suivant des modes de réalisation particuliers, le film comprend une ou plusieurs des caractéristiques suivantes, prise(s) isolément ou suivant toute combinaison techniquement possible :

-   le film comprend au moins un oxyde métallique, l'oxyde métallique présentant une bande de conduction ayant un niveau d'énergie minimal, et au moins un additif, l'additif étant choisi dans le groupe constitué des hydroxydes alcalins, des hydroxydes alcalino-terreux, des matériaux semi-conducteurs de type n et des matériaux dopants de type n, lesdits matériaux semi-conducteurs de type n ayant une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique, et les matériaux dopants de type n ont une énergie d'ionisation inférieure au niveau d'énergie minimal en valeur absolue de la bande de conduction de l'oxyde métallique.

-   le film consiste en au moins un oxyde métallique, l'oxyde métallique présentant une bande de conduction ayant un niveau d'énergie minimal, et au moins un additif, l'additif étant choisi dans le groupe constitué des hydroxydes alcalins, des hydroxydes alcalino-terreux, des matériaux semi-conducteurs de type n et des matériaux dopants de type n, lesdits matériaux semi-conducteurs de type n ayant une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique, et les matériaux dopants de type n ont une énergie d'ionisation inférieure au niveau d'énergie minimal en valeur absolue de la bande de conduction de l'oxyde métallique.

-   le film consiste en au moins un oxyde métallique, l'oxyde métallique présentant une bande de conduction ayant un niveau d'énergie minimal, et au moins un additif, l'additif étant choisi dans le groupe constitué des hydroxydes alcalins, des hydroxydes alcalino-terreux, et des matériaux semi-conducteurs de type n, lesdits matériaux ayant une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique.

-   chaque oxyde métallique est choisi parmi l'oxyde de zinc, l'oxyde de titane, l'oxyde d'étain, leurs dérivés et leurs mélanges.

- le rapport entre la quantité de matière d'additif et la quantité de matière d'oxyde métallique est inférieur ou égal à 10,0%, préférentiellement inférieur ou égal à 5,0%, très préférentiellement inférieur ou égal à 1,0%, la quantité de matière d'additif étant définie comme la somme des quantités de matière de chaque additif, la quantité de matière d'oxyde métallique étant définie comme la somme des quantités de matière de chaque oxyde métallique.
- le rapport entre la quantité de matière d'additif et la quantité de matière d'oxyde métallique est supérieur ou égal à 0,01%, préférentiellement supérieur ou égal à 0,025%.
- chaque additif est un dopant de type n, ledit dopant de type n augmentant la capacité de transport des électrons d'un matériau dopé avec ledit dopant par rapport à la capacité de transport d'un matériau non dopé d'un facteur supérieur ou égal à 1,1.
- chaque additif est un dopant de type n, ledit dopant de type n diminuant le temps d'activation d'un matériau dopé avec ledit dopant par rapport au temps d'activation d'un matériau non dopé d'un facteur supérieur ou égal à 1,1.
- chaque additif est un hydroxyde alcalin ou un hydroxyde alcalino-terreux, avantageusement choisi dans le groupe constitué de l'hydroxyde de sodium, l'hydroxyde de potassium, l'hydroxyde de lithium et l'hydroxyde de baryum.
- le rapport entre la quantité de matière d'additif et la quantité de matière d'oxyde métallique est supérieur ou égal à 0,05% et inférieur ou égal à 1,0%, la quantité de matière d'additif étant définie comme la somme des quantités de matière de chaque additif, la quantité de matière d'oxyde métallique étant définie comme la somme des quantités de matière de chaque oxyde métallique.
- l'additif est le décaméthyl-cobaltocène.
- le film présente une épaisseur comprise entre 30 nanomètres et 100 nanomètres, préférentiellement comprise entre 30 nanomètres et 60 nanomètres, de préférence comprise entre 35 nanomètres et 45 nanomètres.

Il est aussi proposé un procédé de fabrication d'un film pour cellule photovoltaïque comprenant une étape de préparation d'un mélange comprenant au moins un oxyde métallique, l'oxyde métallique présentant une bande de conduction ayant un niveau d'énergie minimal, et au moins un additif, l'additif étant choisi dans le groupe constitué des hydroxydes alcalins, des hydroxydes alcalino-terreux, des matériaux semi-conducteurs et des matériaux dopants de type n, lesdits matériaux semi-conducteurs ayant une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique, et lesdits matériaux dopants de type n ayant une énergie d'ionisation inférieure au niveau d'énergie minimal en valeur absolue de la bande de conduction de l'oxyde métallique. Le procédé comprend également une étape d'enduction du mélange sur un substrat pour former le film, le substrat étant préférentiellement une électrode réalisée en un alliage d'indium et d'étain.

Il est également proposé un procédé de fabrication d'un film pour cellule photovoltaïque comprenant une étape de préparation d'un mélange comprenant au moins un oxyde métallique, l'oxyde métallique présentant une bande de conduction ayant un niveau d'énergie minimal, et au moins un additif, l'additif étant choisi dans le groupe constitué des hydroxydes alcalins, des hydroxydes alcalino-terreux et des matériaux semi-conducteurs de type n, lesdits matériaux semi-conducteurs de type n ayant une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique. Le procédé comprend également une étape d'enduction du mélange sur un substrat pour former le film, le substrat étant préférentiellement une électrode réalisée en un alliage d'indium et d'étain.

Suivant des modes de réalisation particuliers, le procédé de fabrication comprend une ou plusieurs des caractéristiques suivantes, prise(s) isolément ou suivant toute combinaison techniquement possible :

- le procédé comprend une étape de préparation d'un mélange comprenant au moins un oxyde métallique, l'oxyde métallique présentant une bande de conduction ayant un niveau d'énergie minimal, et au moins un additif, l'additif étant choisi dans le groupe constitué des hydroxydes alcalins, des hydroxydes alcalino-terreux, des matériaux semi-conducteurs de type n et des matériaux dopants de type n, lesdits matériaux semi-conducteurs de type n ayant une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique, et lesdits matériaux dopants de type n ayant une énergie d'ionisation inférieure au niveau d'énergie minimal en valeur absolue de la bande de conduction de l'oxyde métallique, le procédé comprenant également une étape d'enduction du mélange sur un substrat pour former le film, le substrat étant préférentiellement une électrode réalisée en un alliage d'indium et d'étain.
- le procédé comprend une unique étape de chauffage postérieure à l'étape d'enduction.
- l'unique étape de chauffage présente une durée, la durée étant inférieure ou égale à 5 minutes, la durée étant préférentiellement supérieure ou égale à 2 minutes, la température lors de la mise en oeuvre de l'unique étape de chauffage étant préférentiellement constante, par exemple constante à une température supérieure ou égale à 100°C et inférieure ou égale à 140°C, préférentiellement égale à 120°C.

Il est également proposé une cellule photovoltaïque comportant un film tel que défini précédemment.

Suivant un mode de réalisation particulier, la cellule photovoltaïque comprend la caractéristique suivant laquelle le film est enduit sur une électrode réalisée en un matériau conducteur notamment choisi parmi une encre à base de nanoparticules d'argent, une encre à base de nanofils d'argent, un alliage d'oxyde d'indium et d'étain, et un mélange de ceux-ci.

Il est aussi proposé un module photovoltaïque comportant au moins une cellule telle que définie précédemment.

BREVE DESCRIPTION DES FIGURES

D'autres caractéristiques et avantages de l'invention apparaîtront à la lecture de la description qui suit de modes de réalisation de l'invention, donnée à titre d'exemple uniquement, et faite en se référant aux dessins annexés, sur lesquels :

- la figure 1 est une vue schématique en coupe d'une cellule photovoltaïque selon un premier mode de réalisation.
- la figure 2 est un graphe représentant l'évolution des courbes courant-tension en fonction du temps d'irradiation lumineuse pour une cellule photovoltaïque dont la couche conductrice d'électron est constituée d'oxyde de zinc.
- la figure 3 est un graphe représentant l'évolution des courbes courant-tension en fonction du temps d'irradiation lumineuse pour une cellule photovoltaïque comprenant un premier additif dans la couche conductrice d'électrons, suivant l'expérience 1.
- la figure 4 est un graphe représentant l'évolution des courbes courant-tension en fonction du temps d'irradiation lumineuse pour une cellule photovoltaïque comprenant un deuxième additif dans la couche conductrice d'électrons, suivant l'expérience 4.
- la figure 5 est un graphe représentant l'évolution de la puissance de conversion électrique (PCE) de la cellule photovoltaïque représentée sur la figure 1 en fonction du temps passé dans une enceinte de vieillissement (irradiation lumineuse continue à 1000 W/m$^2$, avec une lampe au xénon, sous une température de 50°C, humidité non contrôlée), dit « temps de photo-dégradation », suivant l'expérience 2.

DESCRIPTION DE MODES DE REALISATION DE L'INVENTION

Un module photovoltaïque (non représenté ici) est un dispositif propre à convertir de l'énergie solaire reçue en énergie électrique.

Le module photovoltaïque comporte au moins deux cellules photovoltaïques 8 connectées en série ou en parallèle.

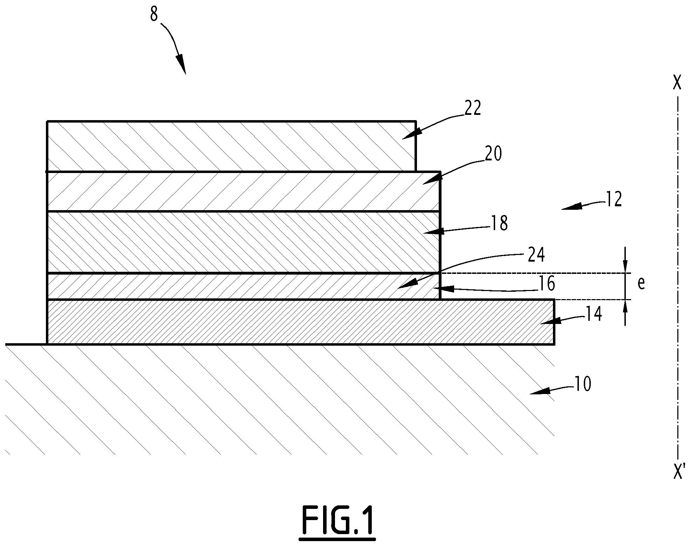

Une cellule photovoltaïque 8 selon un premier mode de réalisation est représentée sur la figure 1.

La cellule photovoltaïque 8 comporte un substrat 10.

Le substrat 10 est une couche planaire. Une direction d'empilement représentée par XX' sur la figure 1 et normale au substrat 10 est définie. La direction d'empilement est donc notée directement direction d'empilement XX' dans la suite.

Avantageusement, le substrat 10 est un substrat flexible réalisé en matière plastique, par exemple du type PET (poly(téréphtalate d'éthylène), plus connu sous le nom anglais de polyethylene terephthalate (parfois francisé de manière impropre en «polyéthylène téréphtalate») ou PEN (poly(naphtalate d'éthylène ou polyéthylène naphtalate).

La cellule photovoltaïque 8 comporte un empilement 12 de cinq couches planaires 14, 16, 18, 20, 22 superposées le long de la direction d'empilement XX'.

L'empilement 12 comporte une première électrode 14, une couche conductrice d'électrons 16, une couche active 18, une couche conductrice de trous 20 et une deuxième électrode 22.

La première électrode 14, aussi appelée « électrode du bas », est en contact avec le substrat 10.

La première électrode 14 est transparente au moins à la lumière visible, c'est-à-dire à des rayonnements dont la longueur d'onde dans le vide est comprise entre 380 nanomètres et 900 nanomètres.

La première électrode 14 est réalisée dans un matériau conducteur. Le matériau conducteur est choisi par exemple parmi une encre à base de nanoparticules d'argent, une encre à base de nanofils d'argent, un alliage d'oxyde d'indium et d'étain, appelé alliage « ITO », et un mélange de ceux-ci.

Une nanoparticule est définie comme une particule dont chaque dimension est comprise entre 1 et 100 nanomètres.

Un nanofil est défini comme un fil présentant un diamètre de dimension maximale comprise entre 1 et 100 nanomètres et s'étendant selon une direction normale à ce diamètre.

La couche conductrice d'électrons 16 est située entre la première électrode 14 et la couche active 18. La couche conductrice d'électrons 16 est destinée à assurer le transport d'électrons entre la couche active 18 et la première électrode 14.

La couche conductrice d'électrons 16 et sa composition seront décrites plus en détail ultérieurement.

La couche active 18 est située entre la couche conductrice d'électrons 16 et la couche conductrice de trous 20.

La couche active 18 comprend un mélange de matériaux semi-conducteurs. La couche active 18 est constituée d'un mélange d'un matériau donneur d'électrons (dit matériau de type p) et d'un matériau accepteur d'électrons (dit matériau de type n).

Par exemple, le matériau donneur d'électrons est choisi parmi :

- le P3HT (acronyme anglais du « poly(3-hexylthiophene-2,5-diyl) »),
- le PBDTTT-C-T (acronyme anglais du « poly((4,8-bis-(2-ethyl-hexyl-thiophene-5-yl)-benzo(1,2-b:4,5-b')dithiophene-2,6-diyl)-alt-(2-(2'-ethyl-hexanoyl)-thieno(3,4-b)thiophen-4,6-diyl)) »),
- le PBDTTT-CF (acronyme anglais du « poly[4,8-bis(2-ethylhexyloxy)-benzo[1,2-b:4,5-b']dithiophene-2,6-diyl-alt-(4-octanoyl-5-fluoro-thieno[3,4-b]thiophene-2-carboxylate)-2,6-diyl] »),
- le PCDTBT (acronyme anglais du « poly[N-9'-heptadecanyl-2,7-carbazole-alt-5,5-(4',7'-di-2-thienyl-2',1',3'-benzothiadiazole)]»),
- le MEH-PPV (acronyme anglais du « poly[2-methoxy-5-(2-ethylhexyloxy)-1,4-phenylenevinylene] »),
- le PTB7 (acronyme anglais du « poly[[4,8-bis[(2-ethylhexyl)oxy]benzo[1,2-b:4,5-b']dithiophene-2,6-diyl][3-fluoro-2-[(2-ethylhexyl)carbonyl]thieno[3,4-b]thiophenediyl]]»),
- le PTB7-Th (acronyme anglais du « thiophenated-PTB7 »),
- le PT8 (acronyme anglais du « poly-benzodithiophene-N-alkylthienopyrroledione »), et
- le PFN (acronyme anglais du « poly[(9,9-bis(3'-(N,N-dimethylamino)propyl)-2,7-fluorene)-alt-2,7-(9,9-dioctylfluorene)]»).

Par exemple, le matériau accepteur d'électrons est choisi parmi le fullerène, le [6,6]-phényl-C61-butyrate de méthyle (aussi noté PC60BM), le [6,6]-phényl C61-butyrique acide méthyl ester (aussi noté C60-PCBM), le [6,6]-phényl C71-butyrique acide méthyl ester (aussi noté C70-PCBM), le bis(1-[3-(methoxycarbonyle)propyle]-1-phényl)[6.6]C62 (aussi noté Bis-C60-PCBM), le 3'Phenyle-3'H-cyclopropa[8,25][5,6]fullerène-C70-bis-D5h(6)-3'butanoïque acide méthyl ester (aussi noté Bis-C70-PCBM), l'indène-C60-bisadduct (aussi noté ICBA), le mono indène nil C60 (ICMA), et les accepteurs non fullerène tels que les dérivés de l'indacénodithiophène, , les dérivés d'indénofluorène, les dérivés de fluorène, les dérivés de pérylène et les dérivés de diimides.

Selon un mode de réalisation particulier, la couche active 18 comprend plusieurs matériaux accepteurs d'électrons et/ou plusieurs matériaux donneurs d'électrons. Par exemple, la couche active 18 est un mélange ternaire comprenant un matériau donneur d'électrons et deux matériaux accepteurs d'électrons ou d'un mélange ternaire comprenant deux matériaux donneurs d'électrons et un matériau accepteur d'électrons.

La couche conductrice de trous 20 est située entre la couche active 18 et la deuxième électrode 22.

La couche conductrice de trous 20 est destinée à assurer le transport de trous entre la couche active 18 et la deuxième électrode 22.

La couche conductrice de trous 20 est réalisée dans un matériau semi-conducteur ou dans un mélange de matériaux semi-conducteurs. De préférence, le mélange de matériaux conducteurs est un mélange de poly(3,4-éthylènedioxythiophène) et de polystyrène sulfonate de sodium, aussi appelé mélange PEDOT : PSS.

La deuxième électrode 22, aussi appelée « électrode du haut », s'étend au moins en partie sur la couche conductrice de trous 20.

La deuxième électrode 22 est réalisée dans un matériau conducteur. Le matériau conducteur est, par exemple, choisi parmi une encre à base d'argent, une encre à base de nanoparticules d'argent, une encre à base de nanofils d'argent, et un mélange de celles-ci.

La couche conductrice d'électrons 16 est réalisée par enduction d'un film 24.

Un film est défini comme une couche homogène continue réalisée en un matériau ou en un mélange de matériaux.

Le film 24 présente une épaisseur e. L'épaisseur e est la dimension du film 24 selon la direction d'empilement XX' mesurée grâce à un profilomètre mécanique

L'épaisseur e du film 24 est relativement faible. Il est entendu par une épaisseur relativement faible, une épaisseur inférieure ou égale à 500 microns.

De préférence, l'épaisseur e du film 24 est comprise entre 30 nanomètres et 100 nanomètres. L'épaisseur e du film 24 est suffisamment grande pour éviter les risques de court-circuit et suffisamment faible pour éviter que les performances électriques de la cellule photovoltaïque 8 diminuent à cause de la résistance série de la cellule photovoltaïque 8.

Avantageusement, l'épaisseur e du film 24 est comprise entre 30 nanomètres et 60 nanomètres, avantageusement comprise entre 35 nanomètres et 45 nanomètres.

Par exemple, l'épaisseur e du film 24 est de 40 nanomètres.

La composition du film 24 représenté sur la figure 1 est maintenant décrite.

Le film 24 comprend au moins un oxyde métallique et au moins un additif.

De préférence, le film 24 est constitué d'au moins un oxyde métallique et d'au moins un additif.

L'oxyde métallique comporte une bande de valence et une bande de conduction. La bande de conduction présente un niveau d'énergie minimal.

Le niveau d'énergie minimal de la bande de conduction est défini comme étant, parmi les bandes d'énergie permises pour un électron dans l'oxyde métallique, l'énergie de la bande qui présente l'énergie la plus basse tout en n'étant pas remplie à une température inférieure ou égale à 20 K.

L'oxyde métallique est choisi dans le groupe constitué de l'oxyde de zinc (ZnO), l'oxyde de titane (TiO$_2$), l'oxyde d'étain (SnO$_2$) et leurs dérivés.

Il est entendu par « dérivé d'un oxyde métallique » un oxyde métallique ayant subi un dopage. Les dérivés sont, par exemple, l'oxyde d'étain dopé à l'antimoine ou l'oxyde de zinc dopé à l'aluminium, aussi appelé selon son appellation anglaise « Aluminium-doped Zinc Oxide » ou AZO.

Dans un cas particulier, l'oxyde métallique est du ZnO ou du TiO$_2$.

Selon l'exemple proposé, le film 24 comprend un unique oxyde métallique.

Seul le mode de réalisation où le film 24 comprend un unique oxyde métallique est détaillé dans la suite. Toutefois, en variante, le film 24 comprend un mélange de plusieurs oxydes métalliques à la place d'un unique oxyde métallique. Par exemple, le film 24 comprend un mélange équimolaire d'oxyde de zinc et d'oxyde d'étain.

Selon l'exemple proposé, le film 24 comprend un unique additif.

L'additif est un composé chimique n'appartenant pas à la classe des oxydes métalliques.

Selon le premier mode de réalisation, l'additif est choisi dans le groupe constitué des hydroxydes alcalins et des hydroxydes alcalino-terreux.

Un hydroxyde alcalin, aussi appelé hydroxyde de métal alcalin, est un composé chimique comportant un cation de métal alcalin et un anion hydroxyde (HO$^-$). Les hydroxydes alcalins sont l'hydroxyde de lithium, l'hydroxyde de sodium, l'hydroxyde de potassium, l'hydroxyde de rubidium, l'hydroxyde de caesium et l'hydroxyde de francium.

Un hydroxyde alcalino-terreux, aussi appelé hydroxyde de métal alcalino-terreux, est un composé chimique comportant un cation de métal alcalino-terreux et un anion hydroxyde (HO$^-$). Les hydroxydes alcalino-terreux sont l'hydroxyde de béryllium, l'hydroxyde de magnésium, l'hydroxyde de calcium, l'hydroxyde de strontium, l'hydroxyde de baryum et l'hydroxyde de radium.

Par exemple, l'additif est choisi dans le groupe constitué de l'hydroxyde de lithium, l'hydroxyde de sodium, l'hydroxyde de potassium et l'hydroxyde de baryum.

Le rapport entre la quantité de matière d'additif et la quantité de matière d'oxyde métallique, aussi appelé « rapport molaire additif : oxyde métallique » ou « ratio additif : oxyde métallique », est le rapport mathématique dont le numérateur est la quantité de matière de l'additif et dont le dénominateur est la quantité de matière de l'oxyde métallique.

Le rapport entre la quantité de matière d'additif et la quantité de matière d'oxyde métallique est inférieur ou égal à 10,0%.

De préférence, le rapport entre la quantité de matière d'additif et la quantité de matière d'oxyde métallique est inférieur ou égal à 5,0%, avantageusement inférieur ou égal à 1,0%, préférentiellement inférieur ou égal à 0,5%, très préférentiellement inférieur ou égal à 0,1%.

Le rapport entre la quantité de matière d'additif et la quantité de matière d'oxyde métallique est supérieur ou égal à 0,01%, avantageusement supérieur ou égal à 0,025%, préférentiellement supérieur ou égal à 0,05%.

Le fonctionnement du module photovoltaïque est maintenant expliqué.

Un rayonnement lumineux atteint le module photovoltaïque au niveau d'une ou de plusieurs cellule(s) photovoltaïque(s) 8. Des photons sont absorbés au niveau de la couche active 18. L'énergie des photons est transférée à des électrons de la couche active 18. Des paires électron-trou sont ainsi générées avant de subir une disjonction.

La couche conductrice d'électrons 16 et la couche conductrice de trous 20 facilitent la disjonction des paires électron-trou.

La couche conductrice de trous 20 assure le transport des trous de la couche active 18 vers la deuxième électrode 22, qui joue le rôle d'anode. La couche conductrice d'électrons 16 assure le transport des électrons de la couche active 18 vers la première électrode 14, qui joue le rôle de cathode.

La présence de l'additif dans la couche conductrice d'électrons 16 en diminue la résistivité, ce qui facilite le transport des électrons jusqu'à la première électrode 14. Toutefois, à ce jour, aucun test n'a permis de mesurer cette diminution de résistivité.

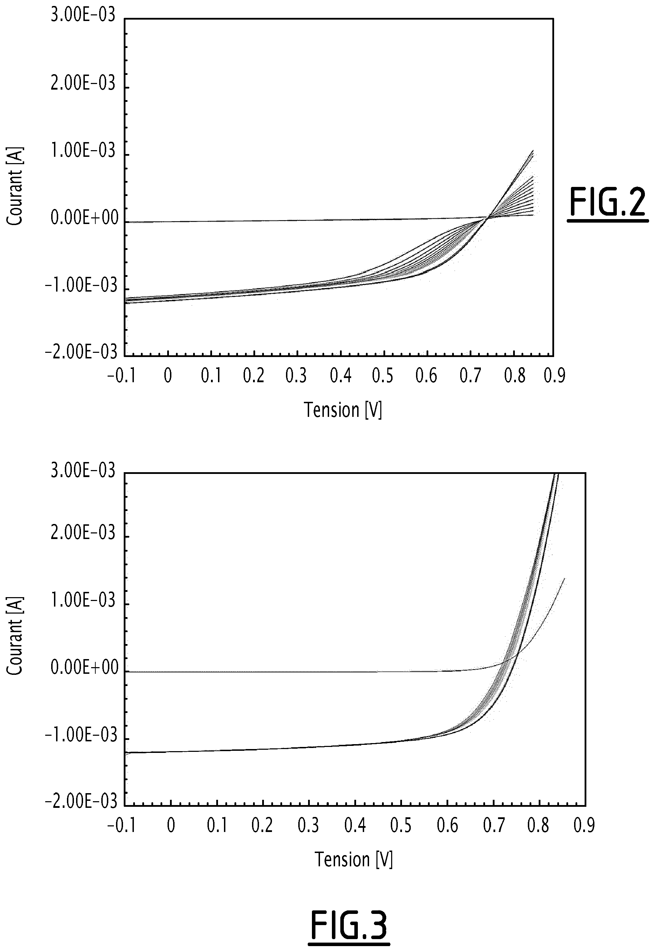

Une cellule photovoltaïque dont la couche conductrice d'électrons est dépourvue d'additif présente une forte résistivité. Cette propriété est notamment visible sur la figure 2 du fait de la présence d'une courbe de mesure courant-tension en forme de S. La résistivité de la couche conductrice d'électrons diminue lorsque la cellule photovoltaïque est exposée pendant une durée croissante à une irradiation lumineuse : au bout du temps de photo-activation, la courbe courant-tension ne présente plus de forme en S.

La courbe de mesure courant-tension de la cellule photovoltaïque 8 selon le premier mode de réalisation, comprenant comme additif de l'hydroxyde de soude, dans un rapport molaire NaOH : ZnO égal à 2,0%, est représentée sur la figure 3. La courbe ne présente pas de forme en S quel que soit le temps d'exposition de la cellule photovoltaïque 8 à une irradiation lumineuse. L'absence de forme en S confirme la plus grande conductivité de la couche conductrice d'électrons 16 comprenant un additif par rapport à une couche conductrice d'électrons qui en est dépourvue.

A la suite du déplacement des électrons et des trous respectivement vers la cathode et vers l'anode, une différence de potentiel apparaît entre les deux électrodes 14, 22 et les cellules photovoltaïques 8 produisent un courant électrique continu. Les cellules photovoltaïques 8 sont connectées entre elles au moyen de raccordements pour former des modules photovoltaïques qui fournissent de l'énergie électrique à un circuit électrique extérieur.

La cellule photovoltaïque 8 est caractérisée électriquement en plaçant la cellule photovoltaïque 8 sous irradiation lumineuse continue. Des courbes courant-tension sont obtenues à partir des mesures courant-voltage et des paramètres photovoltaïques comme le courant de court-circuit $J_{cc}$, la tension à circuit ouvert $V_{co}$, le facteur de forme FF et la puissance de conversion électrique PCE sont extraits.

Les mesures électriques sont effectuées à différents intervalles de temps, par exemple à trois secondes d'intervalle.

Un des paramètres photovoltaïques discriminants dans l'activation d'une cellule photovoltaïque 8 est le facteur de forme, aussi appelé FF. Le facteur de forme FF dépend de la capacité d'extraction des charges par les électrodes. Le pourcentage de variation du facteur de forme, appelé « % variation FF », est mesuré avec le calcul suivant :

$$\%\text{variation FF} = \frac{FF(t+3\text{ s}) - FF(t)}{FF(t)} * 100$$

où :

- FF(t) est le facteur de forme à un instant de temps t donné, et
- FF(t+3sec) est le facteur de forme à l'instant t + 3 secondes.

Le temps d'activation est fixé comme étant la durée avant que le pourcentage de variation du facteur de forme soit inférieur à 0,1 %.

Les cellules photovoltaïques 8 comprenant le film 24 présentent un temps de photo-activation grandement réduit, le temps de photo-activation pouvant en particulier être inférieur à une minute pour certaines compositions. L'expérience 1 détaille les performances électriques de cellules photovoltaïques 8 selon le premier mode de réalisation.

Le rendement de conversion des cellules 8 comprenant le film 24 atteint son maximum en un temps grandement réduit, ce temps pouvant en particulier être inférieur à une minute pour certaines compositions.

Les cellules photovoltaïques 8 selon le premier mode de réalisation fonctionnent sans temps de photo-activation ou avec un temps de photo-activation réduit, tout en maintenant des performances initiales comparables à celles d'une cellule photovoltaïque ne comprenant pas d'additif dans la couche conductrice d'électrons.

De plus, après une exposition de plusieurs heures à une exposition lumineuse continue, les cellules photovoltaïques 8 présentent des performances électriques similaires à celles d'une cellule photovoltaïque ne comprenant pas d'additif dans la couche conductrice d'électrons. La stabilité du film 24 n'est pas réduite par rapport à un film dépourvu d'un additif, comme l'illustrent les résultats de l'expérience 2, détaillée ultérieurement.

D'autre part, après une exposition de plusieurs heures à des températures de 50°C et 85°C (tests de dégradation thermique), les cellules photovoltaïques 8 présentent des performances électriques similaires à celles d'une cellule photovoltaïque n'ayant pas été dégradée thermiquement. L'ajout d'un additif n'entraîne donc pas une dégradation thermique des performances photovoltaïques des cellules photovoltaïques. Ces résultats sont montrés dans l'expérience 3.

Les cellules photovoltaïques 8 sont faciles à fabriquer, ce qui les rend particulièrement adaptées pour une production à grande échelle.

Un procédé de fabrication d'un film 24 pour cellule photovoltaïque 8 selon ce premier mode de réalisation va maintenant être décrit.

Le procédé de fabrication comprend une étape de préparation d'un mélange comprenant l'oxyde métallique et l'additif et une étape d'enduction du mélange sur un substrat pour former le film 24.

Des nanoparticules d'un oxyde métallique sont mises en suspension dans un solvant. L'oxyde métallique est choisi dans le groupe constitué de l'oxyde de zinc (ZnO), l'oxyde de titane ($TiO_2$), l'oxyde d'étain ($SnO_2$) et leurs dérivés.

Le solvant est préférentiellement dépourvu de composé halogéné, particulièrement de composé chloré.

Avantageusement, le solvant présente un point d'auto-inflammation supérieur à 200°C. Le solvant est compatible avec l'emploi d'un séchoir thermique.

Le solvant est ainsi utilisable dans un contexte industriel et limite les risques pour la santé des travailleurs et pour l'environnement.

Le procédé de fabrication du film 24 comporte, en outre, une étape d'ajout de l'additif à la solution comprenant les nanoparticules d'oxyde métallique.

De préférence, la solubilisation de l'additif est réalisée à l'aide d'ultrasons ou par agitation mécanique à l'aide d'un barreau aimanté.

Selon un autre mode de réalisation, le mélange est réalisé par procédé dit « sol-gel ». Un précurseur de l'oxyde métallique est mis en contact avec un catalyseur basique dans un solvant. Le précurseur subit une réaction d'hydrolyse suivie d'une réaction de condensation pour former des amas oligomériques. Les amas sont ensuite dispersés dans une solution pour former un sol auquel est rajouté l'additif.

Par exemple, le précurseur de l'oxyde métallique est l'acétate de zinc dihydraté, le catalyseur basique est la monoéthanolamine et le solvant est l'éthanol absolu. La solution d'acétate de zinc dihydraté en présence de monoéthanolamine dans de l'éthanol absolu est agitée à 45°C pendant une durée de deux heures, puis chaque additif est ajouté pour former le mélange comprenant l'oxyde métallique et le ou les additif(s).

Un mélange comprenant l'oxyde métallique et l'additif est obtenu.

Le procédé de fabrication du film 24 comprend également une étape d'enduction, aussi appelée étape de dépôt, par voie liquide du mélange déposé sur un substrat pour former un film 24.

Le dépôt du mélange est mis en oeuvre suivant une technique choisie dans le groupe constitué par les techniques d'enduction ou d'impression. Par exemple, le mélange est déposé sur le substrat suivant une technique choisie dans le groupe constitué par les techniques d'enduction ou d'impression au déroulé dite Roll-to-Roll, la technique du dépôt à la tournette, la technique d'enduction par racle, la technique d'enduction par filière plate souvent désignée par l'expression anglaise « Slot-Die » signifiant « matrice à fente », les méthodes de sérigraphie, les méthodes de flexographie et les méthodes par jet d'encre.

Par la suite, le terme « enduction » inclura les techniques d'enduction et d'impression énoncées précédemment.

De préférence, le substrat est une électrode réalisée en un matériau conducteur choisi parmi une encre à base de nanoparticules d'argent, une encre à base de nanofils d'argent, un alliage d'oxyde d'indium et d'étain et un mélange de ceux-ci.

Avantageusement, le procédé comprend en outre une unique étape de chauffage postérieure à l'étape d'enduction. L'étape de chauffage facilite l'évaporation du solvant.

Par exemple, l'étape de chauffage est réalisée par une plaque chauffante à l'air libre.

De préférence, l'étape de chauffage présente une durée inférieure ou égale à cinq minutes, avantageusement inférieure ou égale à deux minutes.

L'étape de chauffage est mise en oeuvre à une température constante.

De préférence, l'unique étape de chauffage est mise en oeuvre à une température constante supérieure ou égale à 100°C et inférieure ou égale à 130°C. Par exemple, l'unique étape de chauffage est mise en oeuvre à une température constante égale à 120°C.

Avantageusement, l'étape de chauffage est mise en oeuvre à une température constante égale à 120°C pendant une durée inférieure ou égale à deux minutes.

En variante, l'étape de chauffage comprend une première sous-étape de chauffage, une deuxième sous-étape au cours de laquelle le chauffage est interrompu et une troisième sous-étape de chauffage. De préférence, la durée de la deuxième sous-étape est telle que la température du film 24 au cours de cette étape est supérieure à la température du film 24 avant le début de l'étape de chauffage.

La durée totale de l'étape de chauffage est inférieure ou égale à cinq minutes, de préférence inférieure ou égale à deux minutes.

Le procédé de fabrication est dépourvu d'étapes de recuit longues et coûteuses en énergie.

Un film 24 présentant une épaisseur inférieure à 100 nanomètres est obtenu.

En variante, l'additif est choisi dans le groupe des matériaux semi-conducteurs de type n.

Les matériaux semi-conducteurs de type n présentent une orbitale moléculaire la plus haute occupée, dite orbitale HOMO. L'orbitale HOMO présente un niveau d'énergie.

De préférence, le niveau d'énergie en valeur absolue de la HOMO du semi-conducteur organique de type n est inférieur au niveau d'énergie minimal en valeur absolue de la bande de conduction de l'oxyde métallique.

Le matériau semi-conducteur de type n est choisi dans le groupe constitué du cobaltocène, du décaméthyl-cobaltocène du bis(rhodocène) et du tetrakis(hexahydropyrimidinopyrimidine)ditungstène, leurs dérivés et leurs mélanges.

Autrement formulé, le matériau semi-conducteur de type n est choisi dans le groupe constitué du $CoCp_2$, du $(RhCp_2)_2$, du $W_2(hpp)_2$, leurs dérivés et leurs mélanges.

De préférence, le matériau semi-conducteur de type n est le décaméthyl-cobaltocène.

Le rapport entre la quantité de matière d'additif et la quantité de matière d'oxyde métallique est inférieur ou égal à 10,0%.

De préférence, le rapport entre la quantité de matière d'additif et la quantité de matière d'oxyde métallique est inférieur ou égal à 5,0%, avantageusement inférieur ou égal à 1,0%, très préférentiellement inférieur ou égal à 0,5%.

Le rapport entre la quantité de matière d'additif et la quantité de matière d'oxyde métallique est supérieur ou égal à 0,01%, préférentiellement supérieur ou égal à 0,025%.

Les performances électriques de cellules photovoltaïques 8 comprenant du décaméthyl-cobaltocène dans la couche conductrice d'électrons ont été mesurées et sont détaillées ultérieurement dans l'expérience 4.

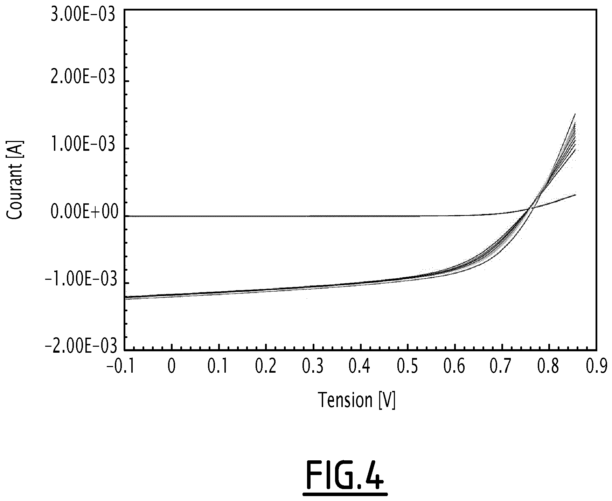

La courbe de mesure courant-tension de la cellule photovoltaïque 8 selon le premier mode de réalisation, comprenant comme additif du décaméthyl-cobaltocène, dans un rapport molaire décaméthyl-cobaltocène : ZnO égal à 0,02%, est représentée sur la figure 4. La courbe ne présente pas de forme en S quel que soit le temps d'exposition de la cellule photovoltaïque 8 à une irradiation lumineuse. L'absence de forme en S confirme la plus grande conductivité de la couche conductrice d'électrons 16 comprenant un additif par rapport à une couche conductrice d'électrons qui en est dépourvue.

En variante, le film comporte un mélange d'additifs choisis dans le groupe constitué des hydroxydes alcalins, des hydroxydes alcalino-terreux, et des matériaux semi-conducteurs de type n, lesdits matériaux ayant une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique.

Selon un autre mode de réalisation, l'additif est choisi parmi les matériaux dopants de type n.

Pour la suite, le terme « dopant de type n » est utilisé pour désigner un matériau dopant de type n.

Un dopant de type n permet, lorsque ledit dopant de type n est mélangé à un matériau non dopé, d'obtenir un matériau dopé.

La présence d'un dopant de type n augmente la densité en électrons du matériau dopé par rapport à la densité en électrons du matériau non dopé.

La densité en électrons du matériau non dopé est comprise entre $10^{10}$ cm$^{-3}$ et $10^{20}$ cm$^{-3}$, et la densité en électrons du matériau dopé est comprise entre $1,1.10^{10}$ cm$^{-3}$ et $10^{25}$ cm$^{-3}$.

La densité en électrons du matériau dopé est augmentée d'au moins 10,0% par rapport à la densité en électrons du matériau non dopé.

Par exemple, la densité en électrons du matériau dopé est déterminée pour un matériau dopé obtenu à partir d'un mélange comprenant un matériau non dopé et un dopant de type n. Le rapport entre la quantité de matière de dopant de type n et la quantité de matière de matériau non dopé dans le mélange est inférieur ou égal à 10%.

Par exemple, la densité en électrons du matériau dopé et du matériau non dopé est déterminée à une température de 300 K.

Selon un exemple particulier, le dopant de type n est un dopant de type n augmentant la capacité de transport des électrons du matériau dopé par rapport à la capacité de transport du matériau non dopé.

La capacité de transport des électrons d'un matériau est définie par la relation suivante :

$$\sigma = \frac{I \times L}{U \times S}$$

où :

- $\sigma$ est la capacité de transport des électrons du matériau,
- I est l'intensité traversant le matériau,
- L est la longueur du matériau,
- U est la tension appliquée entre deux points du matériau séparés par la distance L, et
- S est la section du matériau.

Par exemple, la valeur de la capacité de transport des électrons d'un matériau est déterminée grâce à un dispositif comprenant une couche réalisée en ledit matériau d'une épaisseur L et s'étendant sur une surface S dudit matériau, comprise entre une électrode comprenant de l'oxyde d'indium et d'étain et une électrode comprenant de l'aluminium. La courbe intensité-potentiel du dispositif est alors déterminée. Cette courbe est assimilée à une droite, et la pente de cette droite correspond au terme $\frac{L}{\sigma \times S}$ de l'équation précédente.

En particulier, l'épaisseur L de la couche est égale à 150 nanomètres (nm) et la surface S de la couche est égale à 10,5 millimètres carrés (mm$^2$).

Selon un exemple particulier, le matériau est un matériau dopé ou un matériau non dopé.

Selon un autre exemple, la valeur de la capacité de transport des électrons d'un matériau est déterminée par la méthode Van der Pauw.

Selon un autre exemple encore, la valeur de la capacité de transport des électrons d'un matériau est déterminée par la méthode des quatre pointes.

Pour la suite, un facteur supérieur ou égal à une valeur X est défini comme le fait que le rapport entre la valeur d'un paramètre physique du matériau dopé et la valeur de ce même paramètre physique pour un matériau non dopé est supérieur ou égal à X.

De préférence, le dopant de type n est un dopant de type n augmentant la capacité de transport des électrons du matériau dopé par rapport à la capacité de transport du matériau non dopé d'un facteur supérieur ou égal à 1,1.

Selon un autre exemple particulier, le dopant de type n est un dopant de type n diminuant le temps de photo-activation du matériau dopé par rapport au temps de photo-activation du matériau non dopé.

Une telle diminution du temps d'activation est déterminée en comparant le temps d'activation d'une cellule photovoltaïque comprenant une couche conductrice d'électrons sous la forme d'un film comprenant au moins un matériau dopé avec le temps d'activation d'une cellule photovoltaïque comprenant une couche conductrice d'électrons sous la forme d'un film comprenant au moins un matériau non dopé.

Pour cela, la cellule photovoltaïque est caractérisée électriquement en plaçant ladite cellule photovoltaïque sous irradiation lumineuse continue. Des courbes courant-tension sont obtenues à partir des mesures courant-voltage et des paramètres photovoltaïques comme le courant de court-circuit $J_{cc}$, la tension à circuit ouvert $V_{co}$, le facteur de forme FF et la puissance de conversion électrique PCE sont extraits.

Les mesures électriques sont effectuées à différents intervalles de temps, par exemple à trois secondes d'intervalle.

Le facteur de forme FF dépend de la capacité d'extraction des charges par les électrodes. Le pourcentage de variation du facteur de forme, appelé « % variation FF », est mesuré avec le calcul suivant :

$$\%\text{variation FF} = \frac{\text{FF}(t + 3\text{ s}) - \text{FF}(t)}{\text{FF}(t)} * 100$$

où :

- FF(t) est le facteur de forme à un instant de temps t donné, et
- FF(t + 3 s) est le facteur de forme à l'instant t + 3 secondes.

Le temps d'activation est fixé comme étant la durée avant que le pourcentage de variation du facteur de forme soit inférieur à 0,1 %.

Selon un exemple particulier, le matériau est un matériau dopé ou un matériau non dopé.

De préférence, le dopant de type n est un dopant de type n diminuant le temps de photo-activation du matériau dopé par rapport au temps de photo-activation du matériau non dopé d'un facteur supérieur ou égal à 1,1.

Par exemple, le temps de photo-activation du matériau dopé est déterminé pour un matériau dopé obtenu à partir d'un mélange comprenant un matériau non dopé et un dopant de type n. Le rapport entre la quantité de matière de dopant de type n et la quantité de matière de matériau non dopé dans le mélange est inférieur ou égal à 10%.

Les dopants de type n ont une énergie d'ionisation inférieure au niveau d'énergie minimal en valeur absolue de la bande de conduction du matériau non-dopé.

Il est entendu par « énergie d'ionisation » l'énergie qu'il faut fournir à un atome neutre à l'état gazeux du dopant de type n pour arracher un électron et former un ion positif.

Dans certains cas, l'énergie d'ionisation du dopant de type n est définie comme l'énergie de l'orbitale la plus haute occupée du dopant de type n.

En effet, de manière usuelle, il est employé, pour un matériau inorganique, le terme de bande de conduction minimum et de bande de valence maximum alors que pour un matériau organique, les termes d'orbitale moléculaire la plus basse vacante et orbitale moléculaire la plus haute occupée sont généralement utilisés.

Par ailleurs, les niveaux énergétiques de la bande de conduction minimum et l'orbitale moléculaire la plus basse vacante est définie par l'affinité électronique.

En outre, le niveau énergétique de bande de valence maximum et l'orbitale moléculaire la plus haute occupée est définie par l'énergie de l'ionisation.

Selon un exemple particulier, le dopant de type n est un matériau semi-conducteur de type n.

L'homme du métier comprendra que le terme « matériau semi-conducteur de type n » est donné à titre d'exemple et que l'invention peut être appliquée à tout type de matériaux semi-conducteurs.

Par exemple, les dopants de type n sont des composés aromatiques comprenant au moins un atome de soufre.

Les composés aromatiques comprenant au moins un atome de soufre sont choisis dans le groupe constitué du bis(éthylènedithio)-tétrathiafulvalène (BET-TTF) et du tétrathianaphthacène (TTN).

Selon un autre exemple, les dopants de type n sont choisis dans le groupe constitué des complexes de rhodium, de tungstène et de cobalt.

Les complexes de rhodium, de tungstène et de cobalt comprennent au moins un métal choisi parmi le rhodium, le tungstène et le cobalt, et au moins un ligand organique comprenant au moins un motif cyclopentadiényle, éventuellement substitué, ou au moins un motif hétérocyclique, éventuellement substitué, comprenant au moins un atome d'azote.

De préférence, le ligand organique est choisi dans le groupe constitué du cyclopentadiényle, du pentaméthylcyclopentadiényle et de l'hexahydropyrimidinopyrimidine (hpp).

Selon un exemple particulier, les matériaux dopants de type n sont choisis dans le groupe constitué du cobaltocène, du décaméthyl-cobaltocène du bis(rhodocène) et du tétrakis(hexahydropyrimidinopyrimidine)ditungstène, leurs dérivés et leurs mélanges.

Selon une variante ou en complément, les matériaux dopants de type n ne sont pas choisis dans le groupe constitué de l'oxyde de titane, l'oxyde de zinc, l'oxyde d'étain, l'oxyde de silicium et l'oxyde d'aluminium.

Dans certains cas, les matériaux dopants de type n n'appartiennent pas à la classe des oxydes métalliques.

Selon un exemple particulier, le matériau non dopé est un oxyde métallique.

L'oxyde métallique comporte une bande de valence et une bande de conduction. La bande de conduction présente un niveau d'énergie minimal.

L'oxyde métallique est choisi dans le groupe constitué de l'oxyde de zinc (ZnO), l'oxyde de titane (TiO$_2$), l'oxyde d'étain (SnO$_2$) et leurs dérivés.

Dans un cas particulier, l'oxyde métallique est du ZnO ou du TiO$_2$.

Le rapport entre la quantité de matière de dopant de type n et la quantité de matière de matériau non dopé est le rapport mathématique dont le numérateur est la quantité de matière du dopant de type n et dont le dénominateur est la quantité de matière du matériau non dopé.

Le rapport entre la quantité de matière de dopant de type n et la quantité de matière de matériau non dopé est inférieur ou égal à 10,0%.

De préférence, le rapport entre la quantité de matière de dopant de type n et la quantité de matière de matériau non dopé est inférieur ou égal à 5,0%, avantageusement inférieur ou égal à 1,0%, préférentiellement inférieur ou égal à 0,5%, très préférentiellement inférieur ou égal à 0,1%.

Le rapport entre la quantité de matière de dopant de type n et la quantité de matière de matériau non dopé est supérieur ou égal à 0,01%, avantageusement supérieur ou égal à 0,025%, préférentiellement supérieur ou égal à 0,05%.

Selon un autre mode de réalisation encore, le film comprend un composé choisi dans le groupe constitué de Na$_{2-x}$H$_x$Ti$_2$O$_4$(OH)$_2$ et K$_2$TiO$_3$, x étant un nombre supérieur ou égal à 0 et strictement inférieur à 2.

Dans toutes les variantes précédentes, la cellule photovoltaïque 8 fournit le maximum de puissance électrique plus rapidement qu'une cellule photovoltaïque ne comprenant pas d'additif dans la couche conductrice d'électrons.

EXPERIENCES

Chacune des expériences 1 à 4 a été réalisée au sein du laboratoire « Intégration du Matériau au Système » (IMS). En particulier, les équipements scientifiques de ce laboratoire ont été utilisés. Le laboratoire IMS appartient à l'unité de recherche UMR 5218 et est situé à Talence (code postal 33405), en France.

Les expériences 1 à 4 ont été menées sur des cellules photovoltaïques 8 comprenant un film 24 pour cellule photovoltaïque 8 comprenant au moins un oxyde métallique, afin de déterminer l'effet de l'ajout d'un additif dans le film 24 sur les performances des cellules photovoltaïques 8.

Dans les expériences mises en oeuvre, certains paramètres sont invariants :

- la surface des cellules photovoltaïques 8 est de 10,5 mm$^2$ ;
- le substrat 10 est constitué de verre ;
- l'électrode du bas 14 est constituée d'une couche comprenant un alliage d'oxyde d'indium et d'étain ;
- la couche active 18 est constituée d'un mélange d'un semi-conducteur organique type donneur, plus précisément un polymère donneur à basse bande interdite, c'est-à-dire un polymère conjugué présentant un gap ou une bande interdite, dont l'énergie associée est inférieure à 1,5 eV (électron Volt), et d'un semi-conducteur organique type accepteur, plus précisément un accepteur de type PCBM ;
- la couche conductrice de trous 20 est constituée d'un mélange de poly(3,4-éthylènedioxythiophène) et de poly(styrène sulfonate de sodium (PEDOT : PSS) ;
- l'électrode du haut 22 est constitué d'une couche constituée d'argent;
- le film 24 est préparé à partir d'une formulation nano-particulaire d'oxyde de zinc ;
- la couche conductrice d'électrons 16 est obtenue par dépôt à la tournette du film 24 constitué d'oxyde de zinc et d'un additif ;

- le dépôt du film 24 est réalisé à une température ambiante de 20°C ;
- une fois déposé, le film 24 présente une épaisseur de 40 nanomètres ;
- le film 24 est chauffé une seule fois à 120°C pendant une durée de deux minutes ;
- la cellule photovoltaïque 8 est irradiée avec une lampe aux halogénures métalliques ;
- les mesures électriques se font sous atmosphère inerte dans une boite à gant, et
- un filtre bloquant les longueurs d'onde inférieures à 400 nm est placé entre la lampe irradiant à 700W/m$^2$ et la cellule photovoltaïque 8, pour se placer dans des conditions d'utilisation de cellules photovoltaïques proches des conditions d'utilisation réelle.

Expérience 1

Lors de l'expérience 1, une cellule photovoltaïque 8 selon le premier mode de réalisation est fabriquée. Plusieurs additifs ont été testés dans des proportions croissantes dans les expériences 1a, 1b et 1c.

*Expérience 1a*

Les résultats obtenus avec l'hydroxyde de sodium en tant qu'additif sont présentés dans le tableau suivant.

| Rapport molaire NaOH : ZnO [%] | Temps de photo-activation [s] | Jcc [mA/cm$^2$] | Vco [V] | FF | PCE [%] |
|---|---|---|---|---|---|
| 0 | 93 | 14,26 | 0,74 | 0,60 | 6,32 |
| 0,1 | 93 | 12,82 | 0,73 | 0,57 | 5,38 |
| 0,2 | 81 | 13,16 | 0,74 | 0,58 | 5,85 |
| 1,0 | 36 | Données non disponibles | | | |
| 2,0 | 0 | 13,16 | 0,75 | 0,65 | 6,38 |

*Expérience 1b*

Les résultats obtenus avec l'hydroxyde de lithium en tant qu'additif sont présentés dans le tableau suivant.

| Rapport molaire LiOH : ZnO [%] | Temps de photo-activation [s] | Jcc [mA/cm$^2$] | Vco [V] | FF | PCE [%] |
|---|---|---|---|---|---|
| 0 | 93 | 14,26 | 0,74 | 0,60 | 6,32 |
| 0,05 | 24 | 12,64 | 0,80 | 0,56 | 5,71 |
| 0,10 | 27 | 12,33 | 0,80 | 0,56 | 5,54 |
| 2,00 | 3 | 12,09 | 0,80 | 0,57 | 5,48 |

*Expérience 1c*

Les résultats obtenus avec l'hydroxyde de baryum en tant qu'additif sont présentés dans le tableau suivant.

| Rapport molaire BaOH : ZnO [%] | Temps de photo-activation [s] | Jcc [mA/cm$^2$] | Vco [V] | FF | PCE [%] |
|---|---|---|---|---|---|
| 0 | 93 | 14,26 | 0,74 | 0,60 | 6,32 |
| 0,05 | 30 | 12,24 | 0,80 | 0,56 | 5,46 |
| 0,10 | 39 | 12,36 | 0,79 | 0,56 | 5,53 |
| 2,00 | 3 | 12,23 | 0,78 | 0,56 | 5,31 |

Il apparaît que, pour des rapports molaires de l'additif sur l'oxyde métallique compris entre 0,05% et 2,00%, les cellules photovoltaïques 8 selon le premier mode de réalisation présentent un temps de photo-activation inférieur à une minute, quel que soit l'additif choisi.

Les autres paramètres électriques de la cellule photovoltaïque 8, c'est-à-dire le courant de court-circuit $J_{cc}$, la tension à circuit ouvert $V_{co}$, le facteur de forme FF et la puissance de conversion électrique PCE conservent des valeurs comparables à celles obtenues avec une cellule photovoltaïque dont la couche conductrice d'électrons est constituée d'oxyde de zinc uniquement.

Expérience 2

Des tests de photo-dégradation sont menés sur une cellule photovoltaïque 8 selon l'expérience 1a.

Des cellules photovoltaïques 8 dont la couche conductrice d'électrons 16 comporte ou non de de l'hydroxyde de sodium ont été irradiées à une lumière calibrée (irradiation lumineuse continue à 1000 W/m$^2$, avec une lampe au xénon, sous une température de 50°C, humidité non contrôlée) à une température de 50°C dans une enceinte de vieillissement. L'enceinte de vieillissement accélère les cinétiques de dégradations des composants de la cellule photovoltaïque 8.

La puissance de conversion électrique des cellules photovoltaïques 8 comprenant des proportions d'additif différentes est mesurée à plusieurs heures d'intervalle.

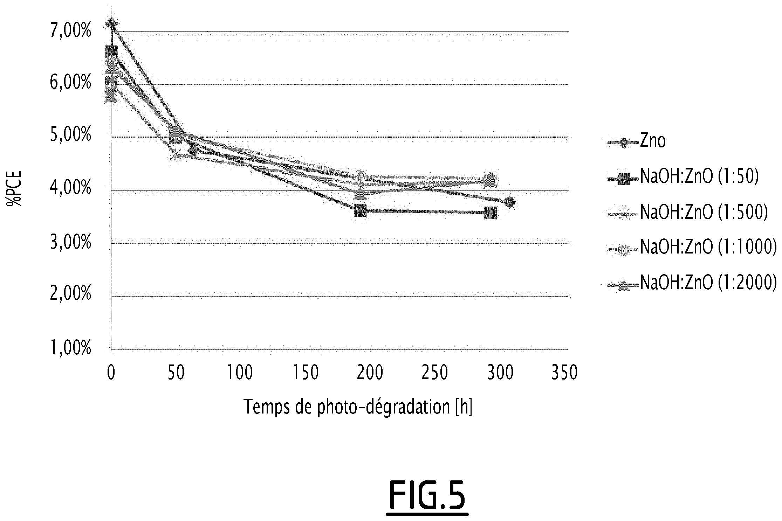

Les résultats sont représentés sur la figure 5. Les résultats obtenus montrent que la puissance de conversion électrique des cellules photovoltaïques 8 comprenant de l'hydroxyde de sodium dans la couche conductrice d'électron 16 est comparable à la puissance de conversion électrique d'une cellule photovoltaïque dont la couche conductrice d'électrons est constituée d'oxyde de zinc.

Des résultats similaires sont obtenus en remplaçant l'hydroxyde de sodium par de l'hydroxyde de baryum, de l'hydroxyde de lithium ou du décaméthyl-cobaltocène.

Il apparaît que l'ajout d'additif dans la couche conductrice d'électrons 16 n'augmente pas la cinétique de photo-dégradation de la cellule photovoltaïque 8.

Expérience 3

Des tests de stabilité thermique et de stockage dans le noir sont menés sur une cellule photovoltaïque 8 selon l'expérience 1a.

Des cellules photovoltaïques 8 dont la couche conductrice d'électrons 16 comprenant de l'hydroxyde de sodium dans un rapport molaire NaOH : ZnO égale à 2,0% ont été soumises à un stockage dans le noir à température ambiante (autour de 25°C) ainsi qu'à des températures de 50°C et 85°C pendant une durée de 141 heures. Soumettre les cellules photovoltaïques 8 à différentes températures de chauffe permet de les dégrader thermiquement afin d'en déterminer la stabilité thermique.

La puissance de conversion électrique des cellules photovoltaïques 8 comprenant de l'hydroxyde de sodium est mesurée avant et après les 141 heures de dégradation dans les différentes conditions.

Les résultats sont représentés sur le tableau ci-dessous.

| Conditions de dégradation | Jcc [mA/cm$^2$] | Vco [V] | FF | PCE [%] |
|---|---|---|---|---|
| Référence (performance initiale) | 13,29 | 0,76 | 0,64 | 6,43 |
| 141 heures à température ambiante | 13,51 | 0,74 | 0,62 | 6,25 |
| 141 heures à 50°C | 13,40 | 0,75 | 0,64 | 6,47 |
| 141 heures à 85°C | 13,48 | 0,75 | 0,61 | 6,20 |

Les résultats obtenus montrent que la puissance de conversion électrique des cellules photovoltaïques 8 comprenant de l'hydroxyde de sodium dans la couche conductrice d'électron 16 est comparable à la puissance de conversion électrique d'une cellule photovoltaïque dont la couche conductrice d'électrons est constituée uniquement d'oxyde de zinc.

Il apparaît que l'ajout d'additif dans la couche conductrice d'électrons 16 ne réduit pas la stabilité thermique au cours du temps de la cellule photovoltaïque 8.

Expérience 4

En variante, une cellule photovoltaïque 8 selon le premier mode de réalisation dans laquelle l'additif est le décaméthyl-cobaltocène est fabriquée.

Les résultats obtenus avec le décaméthyl-cobaltocène en tant qu'additif sont présentés dans le tableau ci-

EP 3 582 276 A1

dessous.

| Rapport molaire Décaméthylcobaltocene : ZnO [%] | Temps de photo-activation [s] | Jcc [mA/cm$^2$] | Vco [V] | FF | PCE [%] |
|---|---|---|---|---|---|
| 0 | 73,8 | 13,52 | 0,77 | 0,59 | 6,08 |
| 0,025 | 39,0 | 13,60 | 0,75 | 0,64 | 6,56 |
| 0,05 | 0 | 11,33 | 0,75 | 0,60 | 5,15 |
| 0,50 | 0 | 5,59 | 0,66 | 0,56 | 2,08 |
| 1,00 | 4,5 | 6,46 | 0,67 | 0,60 | 2,60 |

Il apparaît que, pour des rapports molaires de l'additif sur l'oxyde métallique compris entre 0,025% et 1,00%, les cellules photovoltaïques 8 selon ce mode de réalisation présentent un temps de photo-activation inférieur à une minute.

**Revendications**

1.    Film (24) pour cellule photovoltaïque (8) comprenant :

- au moins un oxyde métallique, l'oxyde métallique présentant une bande de conduction ayant un niveau d'énergie minimal, et
- au moins un additif, l'additif étant choisi dans le groupe constitué :

- des hydroxydes alcalins,
- des hydroxydes alcalino-terreux,
- des matériaux semi-conducteurs, lesdits matériaux ayant une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique, et
- des matériaux dopants de type n, lesdits matériaux ayant une énergie d'ionisation inférieure au niveau d'énergie minimal en valeur absolue de la bande de conduction de l'oxyde métallique.

2.    Film (24) selon la revendication 1, dans lequel le film (24) consiste en :

- au moins un oxyde métallique, l'oxyde métallique présentant une bande de conduction ayant un niveau d'énergie minimal, et
- au moins un additif, l'additif étant choisi dans le groupe constitué :

- des hydroxydes alcalins,
- des hydroxydes alcalino-terreux,
- des matériaux semi-conducteurs de type n, lesdits matériaux ayant une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique, et
- des matériaux dopants de type n, lesdits matériaux ayant une énergie d'ionisation inférieure au niveau d'énergie minimal en valeur absolue de la bande de conduction de l'oxyde métallique.

3.    Film (24) selon la revendication 1 ou 2, dans lequel chaque oxyde métallique est choisi parmi l'oxyde de zinc, l'oxyde de titane, l'oxyde d'étain, leurs dérivés et leurs mélanges.

4.    Film (24) selon l'une quelconque des revendications 1 à 3, dans lequel le rapport entre la quantité de matière d'additif et la quantité de matière d'oxyde métallique est inférieur ou égal à 10,0%, préférentiellement inférieur ou égal à 5,0%, très préférentiellement inférieur ou égal à 1,0%, la quantité de matière d'additif étant définie comme la somme des quantités de matière de chaque additif, la quantité de matière d'oxyde métallique étant définie comme la somme des quantités de matière de chaque oxyde métallique.

5.    Film (24) selon la revendication 4, dans lequel le rapport entre la quantité de matière d'additif et la quantité de matière d'oxyde métallique est supérieur ou égal à 0,01%, préférentiellement supérieur ou égal à 0,025%.

6. Film (24) selon l'une quelconque des revendications 1 à 5, dans lequel chaque additif est un dopant de type n, ledit dopant de type n augmentant la capacité de transport des électrons d'un matériau dopé avec ledit dopant par rapport à la capacité de transport d'un matériau non dopé d'un facteur supérieur ou égal à 1,1.

7. Film (24) selon l'une quelconque des revendications 1 à 5, dans lequel chaque additif est un dopant de type n, ledit dopant de type n diminuant le temps d'activation d'un matériau dopé avec ledit dopant par rapport au temps d'activation d'un matériau non dopé d'un facteur supérieur ou égal à 1,1.

8. Film (24) selon l'une quelconque des revendications 1 à 5, dans lequel chaque additif est un hydroxyde alcalin ou un hydroxyde alcalino-terreux, avantageusement choisi dans le groupe constitué de : l'hydroxyde de sodium, l'hydroxyde de potassium, l'hydroxyde de lithium et l'hydroxyde de baryum.

9. Film (24) selon la revendication 8, dans lequel le rapport entre la quantité de matière d'additif et la quantité de matière d'oxyde métallique est supérieur ou égal à 0,05% et inférieur ou égal à 1,0%, la quantité de matière d'additif étant définie comme la somme des quantités de matière de chaque additif, la quantité de matière d'oxyde métallique étant définie comme la somme des quantités de matière de chaque oxyde métallique.

10. Film (24) selon l'une quelconque des revendications 1 à 7, dans lequel l'additif est le décaméthyl-cobaltocène.

11. Film (24) selon l'une quelconque des revendications 1 à 10, dans lequel le film (24) présente une épaisseur (e) comprise entre 30 nanomètres et 100 nanomètres, préférentiellement comprise entre 30 nanomètres et 60 nanomètres, de préférence comprise entre 35 nanomètres et 45 nanomètres.

12. Procédé de fabrication d'un film (24) pour cellule photovoltaïque (8) comprenant les étapes suivantes :

- préparation d'un mélange comprenant :

- au moins un oxyde métallique, l'oxyde métallique présentant une bande de conduction ayant un niveau d'énergie minimal, et
- au moins un additif, l'additif étant choisi dans le groupe constitué :

- des hydroxydes alcalins,
- des hydroxydes alcalino-terreux,
- des matériaux semi-conducteurs, lesdits matériaux semi-conducteurs ayant une orbitale moléculaire la plus haute occupée, ladite orbitale moléculaire ayant un niveau d'énergie en valeur absolue inférieur au niveau d'énergie minimal en valeur absolue de la bande de conduction de l'oxyde métallique, et
- des matériaux dopants de type n, lesdits matériaux dopants de type n ayant une énergie d'ionisation inférieure au niveau d'énergie minimal en valeur absolue de la bande de conduction de l'oxyde métallique, et

- enduction du mélange sur un substrat pour former le film (24), le substrat étant préférentiellement une électrode (14) réalisée en un alliage d'indium et d'étain.

13. Procédé selon la revendication 12, dans lequel le procédé comprend une unique étape de chauffage postérieure à l'étape d'enduction, ladite unique étape de chauffage présentant une durée, la durée étant inférieure ou égale à 5 minutes, la durée étant préférentiellement supérieure ou égale à 2 minutes, la température lors de la mise en oeuvre de l'unique étape de chauffage étant préférentiellement constante, par exemple constante à une température supérieure ou égale à 100°C et inférieure ou égale à 140°C, préférentiellement égale à 120°C.

14. Cellule photovoltaïque (8) comportant un film (24) selon l'une quelconque des revendications 1 à 11.

15. Module photovoltaïque comportant au moins une cellule (8) selon la revendication 14.

FIG.1

FIG.2

FIG.3

FIG.4

FIG.5

EP 3 582 276 A1

Europäisches
Patentamt

European
Patent Office

Office européen
des brevets

**RAPPORT DE RECHERCHE EUROPEENNE**

Numéro de la demande

EP 19 17 9733

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2010/063973 A1 (SAINT GOBAIN [FR]; AUVRAY STEPHANE [FR]; DAO THIEN HAI [VN]; VENKATARA) 10 juin 2010 (2010-06-10) * page 17, ligne 6 - ligne 9; figure 1 * * page 18, ligne 1113 * * page 31, ligne 27 - ligne 31 * * page 25, ligne 19 - ligne 20; figure 2 * | 1-3,9, 10,12-15 | INV. H01L51/44 H01L31/18 H01L51/42 H01L31/0224 H01L51/00 |
| X | US 2009/308444 A1 (PETER EMMANUELLE [FR] ET AL) 17 décembre 2009 (2009-12-17) * alinéas [0029], [0030], [0051], [0052], [0054], [0058] * | 1-3, 11-15 | |
| X | EP 2 116 534 A1 (UBE INDUSTRIES [JP]) 11 novembre 2009 (2009-11-11) * alinéa [0118] - alinéa [0122] * | 1,10 | |
| T | CHIEN-CHENG TSAI ET AL: "Structural Features of Nanotubes Synthesized from NaOH Treatment on TiO 2 with Different Post-Treatments", CHEMISTRY OF MATERIALS, vol. 18, no. 2, 24 janvier 2006 (2006-01-24), pages 367-373, XP055562950, ISSN: 0897-4756, DOI: 10.1021/cm0518527 * page 368, colonne 2, ligne 14 - ligne 22 * * page 371, colonne 1, ligne 4 - colonne 2, ligne 33 * * page 372, colonne 2, ligne 4 * | 1 | DOMAINES TECHNIQUES RECHERCHES (IPC) H01L H01M |
| T | FR 779 422 A (TITAN GMBH) 4 avril 1935 (1935-04-04) * page 2, colonne 1, ligne 39 * | 1 | |

-/--

Le présent rapport a été établi pour toutes les revendications

| Lieu de la recherche | Date d'achèvement de la recherche | Examinateur |
|---|---|---|
| Munich | 30 octobre 2019 | Pusch, Catharina |

EPO FORM 1503 03.82 (P04C02)

page 1 de 3

Europäisches
Patentamt

European
Patent Office

Office européen
des brevets

# RAPPORT DE RECHERCHE EUROPEENNE

Numéro de la demande

EP 19 17 9733

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | CAROLYN N. VALDEZ ET AL: "Proton-Controlled Reduction of ZnO Nanocrystals: Effects of Molecular Reductants, Cations, and Thermodynamic Limitations", JOURNAL OF THE AMERICAN CHEMICAL SOCIETY, vol. 138, no. 4, 5 janvier 2016 (2016-01-05), pages 1377-1385, XP055562878, ISSN: 0002-7863, DOI: 10.1021/jacs.5b12182 * page 1378, colonne 2, ligne 5 - ligne 15 * <br><br> * page 1377, colonne 1, ligne 3 * * page 1380, colonne 1, ligne 8 - ligne 13 * <br><br>----- | 1-7,10, 12,14,15 | |
| X | JINGJING CHANG ET AL: "Solution-Processed LiF-Doped ZnO Films for High Performance Low Temperature Field Effect Transistors and Inverted Solar Cells", ACS APPLIED MATERIALS & INTERFACES, vol. 5, no. 14, 17 juin 2013 (2013-06-17), pages 6687-6693, XP55637381, US ISSN: 1944-8244, DOI: 10.1021/am4014488 | 1-7, 12-15 | |
| Y | * page 6688, colonne 2, ligne 16 - page 6689, colonne 1, ligne 2; figure 6 * * page 6688, colonne 1, ligne 18 - ligne 22 * * page 6692, colonne 1, ligne 34 - ligne 37; tableau 1 * * page 6689, colonne 2, ligne 18 - ligne 22 * <br><br>----- | 1-7,10, 12,14,15 | |
| X | EP 2 408 023 A1 (APPLIED MATERIALS INC [US]) 18 janvier 2012 (2012-01-18) * alinéas [0047], [0059] * <br>----- <br>-/-- | 1-9,14, 15 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| Munich | 30 octobre 2019 | Pusch, Catharina |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P04C02)

page 2 de 3

Europäisches
Patentamt

European
Patent Office

Office européen
des brevets

**RAPPORT DE RECHERCHE EUROPEENNE**

Numéro de la demande

EP 19 17 9733

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2012/001689 A1 (YEDA RES & DEV [IL]; HODES GARY [IL] ET AL.) 5 janvier 2012 (2012-01-05) * page 14, ligne 17 - ligne 20 * ----- | 1,3,8, 11,14,15 | |
| X | EP 1 981 118 A1 (SONY CORP [JP]) 15 octobre 2008 (2008-10-15) * alinéas [0046], [0056] * ----- | 1,3 | |
| A | US 3 816 178 A (TAKAHASHI H ET AL) 11 juin 1974 (1974-06-11) * colonne 3, ligne 5 - ligne 15; tableau 1 * * revendication 1 * ----- | 1-15 | |

DOMAINES TECHNIQUES
RECHERCHES (IPC)

Le présent rapport a été établi pour toutes les revendications

| Lieu de la recherche | Date d'achèvement de la recherche | Examinateur |
|---|---|---|
| Munich | 30 octobre 2019 | Pusch, Catharina |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
.......................................................
& : membre de la même famille, document correspondant

EPO FORM 1503 03.82 (P04C02)

page 3 de 3

**ANNEXE AU RAPPORT DE RECHERCHE EUROPEENNE
RELATIF A LA DEMANDE DE BREVET EUROPEEN NO.**

EP 19 17 9733

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

30-10-2019

| Document brevet cité au rapport de recherche | Date de publication | Membre(s) de la famille de brevet(s) | Date de publication |
|---|---|---|---|
| WO 2010063973 A1 | 10-06-2010 | BR PI0923287 A2<br>CN 102308391 A<br>EP 2386119 A1<br>FR 2939563 A1<br>JP 2012511247 A<br>KR 20110095926 A<br>US 2012048364 A1<br>WO 2010063973 A1<br>ZA 201104870 B | 26-01-2016<br>04-01-2012<br>16-11-2011<br>11-06-2010<br>17-05-2012<br>25-08-2011<br>01-03-2012<br>10-06-2010<br>28-03-2012 |
| US 2009308444 A1 | 17-12-2009 | CN 102057494 A<br>FR 2932610 A1<br>US 2009308444 A1<br>WO 2010001013 A2 | 11-05-2011<br>18-12-2009<br>17-12-2009<br>07-01-2010 |
| EP 2116534 A1 | 11-11-2009 | AU 2008210694 A1<br>CN 101663277 A<br>EP 2116534 A1<br>JP 5293190 B2<br>JP WO2008093742 A1<br>KR 20090104901 A<br>US 2010006805 A1<br>WO 2008093742 A1 | 07-08-2008<br>03-03-2010<br>11-11-2009<br>18-09-2013<br>20-05-2010<br>06-10-2009<br>14-01-2010<br>07-08-2008 |
| FR 779422 A | 04-04-1935 | AUCUN | |
| EP 2408023 A1 | 18-01-2012 | CN 102339900 A<br>EP 2408023 A1<br>US 2012012172 A1 | 01-02-2012<br>18-01-2012<br>19-01-2012 |
| WO 2012001689 A1 | 05-01-2012 | CN 103119674 A<br>EP 2589057 A1<br>US 2013098440 A1<br>WO 2012001689 A1 | 22-05-2013<br>08-05-2013<br>25-04-2013<br>05-01-2012 |
| EP 1981118 A1 | 15-10-2008 | CN 101937778 A<br>EP 1981118 A1<br>JP 2007234580 A<br>KR 20080094021 A<br>TW 200746491 A<br>US 2009217979 A1<br>WO 2007088871 A1 | 05-01-2011<br>15-10-2008<br>13-09-2007<br>22-10-2008<br>16-12-2007<br>03-09-2009<br>09-08-2007 |
| US 3816178 A | 11-06-1974 | DE 2118541 A1<br>GB 1320611 A<br>JP S4813775 B1 | 11-11-1971<br>20-06-1973<br>28-04-1973 |

EPO FORM P0460

Pour tout renseignement concernant cette annexe : voir Journal Officiel de l'Office européen des brevets, No.12/82

page 1 de 2

**ANNEXE AU RAPPORT DE RECHERCHE EUROPEENNE
RELATIF A LA DEMANDE DE BREVET EUROPEEN NO.**

EP 19 17 9733

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

30-10-2019

| Document brevet cité<br>au rapport de recherche | Date de<br>publication | Membre(s) de la<br>famille de brevet(s) | Date de<br>publication |
|---|---|---|---|
| | | US 3816178 A | 11-06-1974 |

Pour tout renseignement concernant cette annexe : voir Journal Officiel de l'Office européen des brevets, No.12/82

page 2 de 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **LILLIEDAL M. et al.** The effect of post processing treatments on inflection points in current-voltage curves of roll-to-roll processed polymer photovoltaics. *Sol. Energy Mat. & Solar cells,* 2010, vol. 94, 2018-2031